# EUROPEAN PATENT APPLICATION

(11) **EP 1 677 436 A2**
(43) Date of publication of application: **05.07.2006**
(21) Application number: 05028104.7
(22) Date of filing: 21.12.2005
(51) Int. Cl.: H04B 7/08, H04L 27/26, H04N 5/52, H03G 3/20

(54) **Diversity receiver**

(30) Priority: 28.12.2004 JP 2004378695
(71) Applicant: ALPS ELECTRIC CO., LTD., Tokyo 145-8501 (JP)
(72) Inventor: Oyama, Toru c/oAlps Electric Co., Ltd., Tokyo 145-8501 (JP); Takayama, Akira c/oAlps Electric Co., Ltd., Tokyo 145-8501 (JP); Kitada, Kazutoshi c/oAlps Electric Co., Ltd., Tokyo 145-8501 (JP); Otaki, Yukio c7oAlps Electric Co., Ltd., Tokyo 145-8501 (JP)
(74) Representative: Klunker . Schmitt-Nilson . Hirsch

(57) **Abstract**

A diversity receiver is provided which includes: a plurality of antenna blocks (20) each having an antenna (21) and an amplifier (22) coupled to the antenna (21); a plurality of tuner modules (40) each having a tuner (41) and an OFDM demodulator (42) connected to the tuner (41), and each connected to an output terminal of each of the antenna blocks (20); and a synthesizer (60) that synthesizes demodulated signals output from the tuner modules (40), in which when the level of a received signal is greater than a predetermined value, the level of the received signal input to the amplifier (22a) of at least one (20a) of the antenna blocks (20) is lowered or becomes zero, and the level of the received signal is input to the amplifier (33b) of at least another one (20b) of the antenna blocks (20) regardless of change of the level of the received signal without changing the level of the received signal.

## Description

### BACKGROUND OF THE INVENTION

### 1. Field of the Invention

The present invention relates to a diversity receiver, such as a vehicle TV or a portable TV, which can be viewed during movement.

### 2. Description of the Related Art

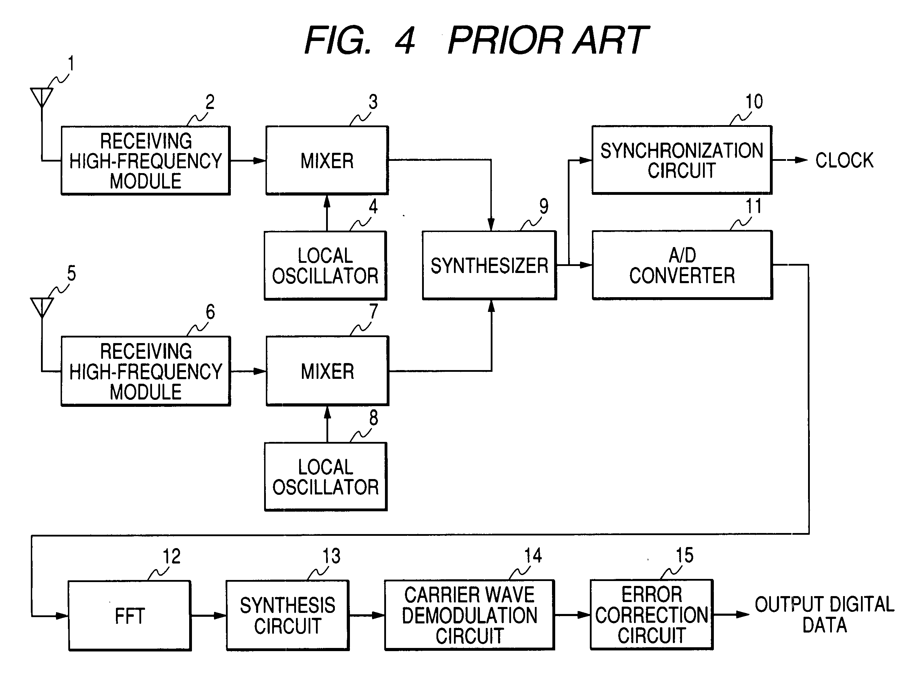

A diversity receiver according to the related art will now be described with reference to Fig. 4. OFDM signals with the same high frequency, which are received by reception antennas 1 and 5, are amplified by receiving high-frequency modules 2 and 6, and are input to mixers 3 and 7, respectively. Local oscillating signals of different but neighboring frequencies are transmitted from local oscillators 4 and 8 to the mixers 3 and 7. Thus, intermediate frequency signals of different but neighboring frequencies are output from the mixers 3 and 7. The intermediate frequency signals output from the mixers 3 and 7 are synthesized by a synthesizer 9. Clocks used by a synchronization circuit 10 in the receiver are reproduced from the synthesizer 9, and a digital signal is obtained by an A/D converter 11.

The digital signal is converted by an FFT 12 into signals corresponding to carrier waves having individual frequencies that constitute the OFDM signal. The converted signals are diversity-synthesized by a synthesizing circuit 13. The synthesized signals are demodulated for every carrier wave by a carrier wave demodulation circuit 14, are subjected to an error correction process by an error correction circuit 15, and are output as digital data (for example, see JP-A No. 2000-041020 (Fig. 1)).

When TV signals or the like are received through a receiver mounted on mobile equipment, the electric field intensity may range, for example, from +10 dBm to -90 dBm, as the mobile equipment moves. Thus, when OFDM signals having a plurality of carriers, such as terrestrial digital TV signals, are received in a strong electric field area, an amplifier incorporated in a receiving high-frequency module is deformed, causing C/N to deteriorate and reception error to occur.

### SUMMARY OF THE INVENTION

It is an object of the invention to improve reception sensitivity in a weak electric field area, and to remove reception error in a strong electric field area by reducing deformation.

According to a first aspect of the invention, there is provided a diversity receiver which includes: a plurality of antenna blocks each having an antenna and an amplifier coupled to the antenna; a plurality of tuner modules each having a tuner and an OFDM demodulator connected to the tuner, and each connected to an output terminal of each of the antenna blocks; and a synthesizer that synthesizes demodulated signals output from the tuner modules. In the diversity receiver, when the level of a received signal is greater than a predetermined value, the level of the received signal input to the amplifier of at least one of the antenna blocks is lowered or becomes zero, and the level of the received signal is input to the amplifier of at least another one of the antenna blocks regardless of change of the level of the received signal without changing the level of the received signal.

According to a second aspect of the invention, the diversity receiver may be configured such that the at least one of the antenna blocks includes a variable attenuator that is located at a front stage of the amplifier, the tuner module connected to the at least one of the antenna blocks includes an AGC generation circuit that generates an AGC voltage which changes when the level of the received signal is greater than the predetermined value, and the amount of attenuation of the variable attenuator is controlled by the AGC voltage.

According to a third aspect of the invention, the diversity receiver may be configured such that the received signal output from each antenna block is input to the tuner module through a first cable, the AGC voltage is input to the variable attenuator through a second cable, the tuner module includes a power supply unit that additionally supplies a power supply voltage to the first cable, and the power supply voltage is supplied from the first cable to the amplifier.

According to a fourth aspect of the invention, the diversity receiver may be configured such that a bypass circuit is provided parallel to the amplifier of the at least one of the antenna blocks to bypass the amplifier, and the received signal is output through the bypass circuit, instead of being input to the amplifier of the at least one of the antenna blocks, only when the level of the received signal is greater than the predetermined value.

According to a fifth aspect of the invention, the diversity receiver may be configured such that the at least one of the antenna blocks includes a switch diode that is interposed between the antenna and the amplifier, the bypass circuit is formed of a switch that is connected between an input terminal of the switch diode and an output terminal of the amplifier, and, when the level of the received signal is greater than the predetermined value, the switch diode is turned off and, at the same time, the switch is turned on.

According to a sixth aspect of the invention, the diversity receiver may be configured such that the received signal output from each of the antenna blocks is input to each of the tuner modules through a first cable, each of the tuner modules includes a power supply unit that supplies a power supply voltage to the first cable, the power supply voltage is supplied to each amplifier through each cable, and the tuner module connected to the at least one of the antenna blocks stops supplying the power supply voltage to the first cable by means of the power supply unit when the level of the received signal is greater than the predetermined value, such that the switch diode is turned off and, at the same time, the switch is turned on.

According to a seventh aspect of the invention, the diversity receiver may be configured such that the switch is formed of an FET, an anode of the switch diode is coupled to an input terminal of the amplifier, a cathode of the switch diode is coupled to the antenna, a source of the FET is connected to the cathode of the switch diode and is put to earth through a bias resistor, a gate of the FET is put to earth, and a drain of the FET is coupled to an output terminal of the amplifier.

According to an eighth aspect of the invention, the diversity receiver may be configured such that the tuner module connected to the at least one of the antenna blocks includes: a detector that detects the level of the received signal, and a comparator in which a reference voltage indicating the predetermined value is input to an input terminal of the comparator and a detected voltage from the detector is input to another terminal of the comparator, in which the power supply unit is formed of a transistor whose collector is connected to a power supply, whose emitter is connected to the first cable, and whose base is connected to an output terminal of the comparator.

### BRIEF DESCRIPTION OF THE DRAWINGS

Fig. 1 is a circuit diagram of a diversity receiver according to a first embodiment of the invention;
Fig. 2 is a circuit diagram of an AGC voltage generation circuit that is used in the diversity receiver according to the first embodiment of the invention;
Fig. 3 is a circuit diagram of a diversity receiver according to a second embodiment of the invention; and
Fig. 4 is a circuit diagram of a diversity receiver according to the related art.

### DESCRIPTION OF THE PREFERRED EMBODIMENT

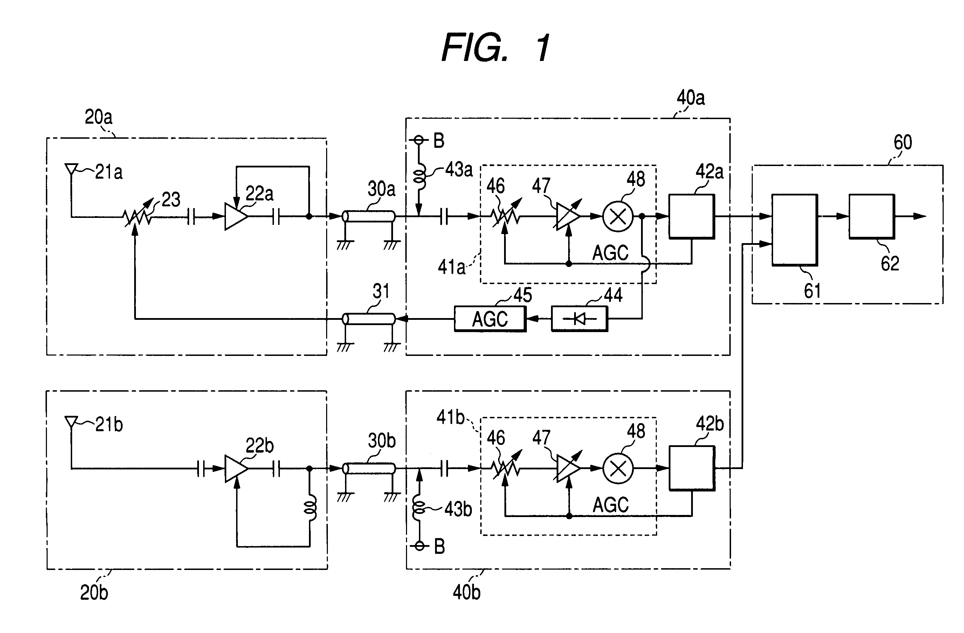

A diversity receiver according to a first embodiment of the invention will now be described with reference to Fig. 1. In Fig. 1, a plurality of antenna blocks 20 (20a, 20b, ...) is connected to a plurality of tuner modules 40 (40a, 40b, ...) through cables 30 (30a, 30b) and 31. In addition, the individual tuner modules 40 are connected to a synthesizer 60. The antenna blocks 20 are mounted, for example, on a front glass of a vehicle. The tuner modules 40, the synthesizer 60, and a display device, which is connected to an output terminal of the synthesizer 60, are connected for grounding to the inside of a main body of the vehicle.

Each antenna block 20 includes at least an antenna 21 (21a, 21b, ...) and an amplifier 22 (22a, 22b, ...) connected to the antenna 21. An OFDM-modulated digital TV signal is received through the antenna 21. At least one 20a of the antenna blocks includes the antenna 21a, the amplifier 22a, and a variable attenuator 23 that is interposed between the antenna 21a and the amplifier 22a. At least another one 20b of the antenna blocks includes the antenna 21b and the amplifier 22b. A power supply voltage is applied to each amplifier 22 from a corresponding cable 30.

The tuner module 40a, which corresponds to the at least one 20a of the antenna blocks, includes a tuner 41a, an OFDM demodulator 42a connected to the tuner 41a, a power supply unit 43a for supplying a power supply voltage to the cable 30a, a detector 44, and an AGC voltage generation circuit 45.

The tuner 41a includes a variable attenuator 46, a variable gain amplifier 47, and a frequency converter 48, which are connected to one another as shown in Fig. 1. The frequency converter 48 converts a received signal to an intermediate frequency signal and outputs the intermediate frequency signal to the OFDM demodulator 42a. The OFDM demodulator 42a outputs a demodulated signal and an AGC voltage. The AGC voltage is supplied to the variable attenuator 46 and the variable gain amplifier 47.

The intermediate frequency signal is input to the detector 44. A detected voltage output from the detector 44 indicates the level of the received signal. The AGC voltage generation circuit 45 generates an AGC voltage that changes when the level of the received signal is greater than a predetermined value. Accordingly, the AGC voltage remains at a constant value when the level of the received signal is less than the predetermined value. The AGC voltage is supplied to the variable attenuator 23 through the cable 31.

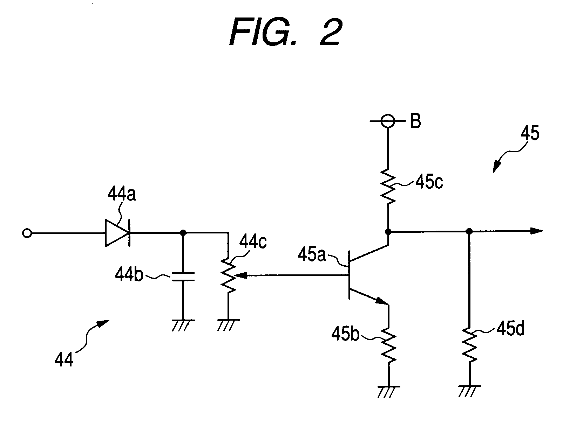

Fig. 2 shows an example of the construction of the detector 44 and the AGC voltage generation circuit 45. The detector 44 includes a detection diode 44a, a capacitor 44b, and a variable resistor 44c. A detection voltage held in the capacitor 44b is applied to the AGC voltage generation circuit 45 through the variable resistor 44c. The AGC voltage generation circuit 45 includes a transistor 45a, an emitter bias resistor 45b, a feeder-side resistor 45c connected to the collector of the transistor 45a (hereinafter, referred to as a 'feeder-side transistor 45c'), and a ground-side resistor 45d connected to the collector of the transistor 45a (hereinafter, referred to as a 'ground-side transistor 45d'). The AGC voltage is output from a collector. A starting point at which the AGC voltage changes is determined by a division ratio of the variable resistor 44c, the emitter bias resistor 45b, the feeder-side resistor 45c, and the ground-side resistor 45d.

The power supply unit 43a is formed of a choke coil.

The tuner module 40b, which corresponds to at least another one 20b of the antenna blocks, includes the tuner 41b, the OFDM demodulator 42b connected to the tuner 41b, and the power supply unit 43b for additionally supplying a power supply voltage to the cable 30b. The tuner 41b, the OFDM demodulator 42b, and the power supply unit 43b have the same configurations as the tuner 41a, the OFDM demodulator 42a, and the power supply unit 43a, respectively.

The synthesizer 60 includes a synthesizing circuit 61 and an error correction circuit 62. The synthesizing circuit 61 synthesizes demodulated signals that are output from the OFDM demodulator 42a and 42b of the tuner modules 40. The error correction circuit 62 corrects bit error and outputs a corrected MPEG digital video signal (transport stream).

According to the above-mentioned construction, in the receiving system on the side of antenna block 20a, when a detection voltage obtained by the detector 44 is less than a predetermined reception level, i.e., when the electric field intensity of a received signal is lower than a predetermined value, the AGC voltage is maintained at a constant value, and the signal received through the antenna 21a is input to the amplifier 22a without being attenuated. The received signal is amplified by the amplifier 22a and then is input to the tuner module 40a through the cable 30a. Then, a demodulated signal is output from the OFDM demodulator 42a. A signal that is received in another antenna block 20b is amplified by the amplifier 22b and input to the tuner module 40b. Then a demodulated signal is also output from the OFDM demodulator 42b. The individual demodulated signals are synthesized. Accordingly, its reception sensitivity is improved.

On the other hand, when the electric field intensity is greater than the predetermined value, the amount of attenuation of the variable attenuator 23 increases corresponding to the reception intensity by the AGC voltage, and the signal received through the antenna 21a is attenuated by the variable attenuator 23 and then is input to the amplifier 22a. Accordingly, since deformation does not occur in the amplifier 22a, C/N is not deteriorated in the tuner 41a and reception error does not occur after a demodulation step. In addition, since another antenna block 20b receives a signal regardless of the magnitude of the electric field intensity, synchronization does not fail in a synthesizing step after the OFDM demodulation even though the electric field intensity weakens.

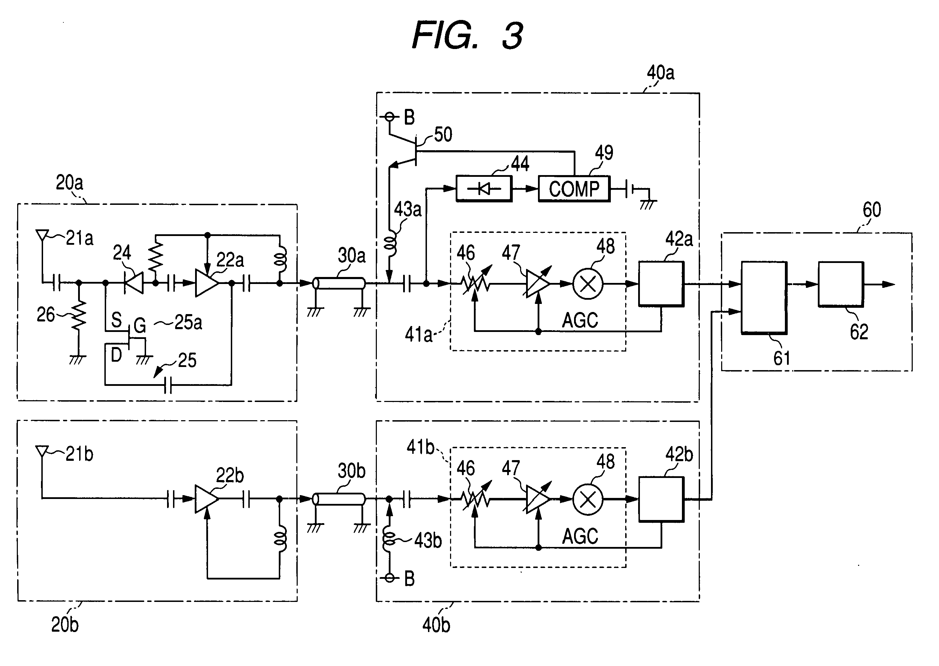

Fig. 3 shows a second embodiment. In Fig. 3, the same components as those of Fig. 1 are denoted by the same reference numerals and detailed description thereof will be omitted herein.

At least one antenna block 20a includes a switch diode 24, which is interposed between the antenna 21a and the amplifier 22a, and a bypass circuit 25, which is connected between an input side of the switch diode 24 and an output side of the amplifier 22a to bypass the amplifier 22a. The bypass circuit 25 is formed of an FET (depletion-type field effect transistor) 25a, which acts as a switch. An anode of the switch diode 24 is coupled to the amplifier 22a, and its cathode is coupled to the antenna 21a. The cathode of the switch diode 24 is put to earth through the bias resistor 26 and is connected to the source of the FET 25a. The gate of the FET 25a is put to earth, and its drain is coupled to an output terminal of the amplifier 22a. A power supply voltage is applied from the cable 30a to the anode of the switch diode 24.

The tuner module 40a, which corresponds to the antenna block 20a, includes a detector 44, a comparator 49, and a transistor (PNP transistor) 50. The transistor 50 is also a power supply unit, in which its collector is pulled up to a power supply, and its emitter is connected to the choke coil 43a. Accordingly, when the transistor 50 is turned on, a power supply voltage is additionally supplied to the cable 30a. However, when the transistor 50 is turned off, the power supply voltage is not supplied.

The detector 44 detects a received signal that is input to the tuner 41a. The detected voltage is input to an input terminal of the comparator 49. A reference voltage Vref, which corresponds to a predetermined received signal level, is input to another input terminal of the comparator 49. The comparator 49 outputs a low level of voltage when the detected voltage is less than the reference voltage, and outputs a high level of voltage when the detected voltage is greater than the reference voltage.

According to the above configuration, when the level of the received signal is less than the predetermined value, the detected voltage is less than the reference voltage and the output of the comparator 49 becomes a low level, such that the transistor 50 is turned on. Accordingly, a power supply voltage is supplied to the cable 30a and also supplied to the amplifier 22a through the cable 30a. At this time, the switch diode 24 is turned on and the FET 25a is turned off. Thus, the received signal received by the antenna 21a is amplified by the amplifier 22a, and is then input to the tuner 41a through the cable 30a. Further, since another antenna block 20b receives a signal regardless of the magnitude of the electric field intensity, synchronization does not fail in the synthesizing step after the OFDM demodulation. The reception sensitivity is also improved.

On the other hand, when the level of the received signal is greater than the predetermined value, the detected voltage obtained by the detector 44 is greater than the reference voltage and the output of the comparator 49 becomes a high level, such that the transistor 50 is turned off. Accordingly, a power supply voltage is not supplied to the cable 30a and the amplifier 22a, and the switch diode 24 is turned off, such that the FET 25a is turned on. Accordingly, the received signal is output through the bypass circuit 25 instead of being input to the amplifier 22a. Also, since the power supply voltage is not supplied, the amplifier 22a also stops operating. Accordingly, even though the received electric field intensity becomes high, deformation does not occur due to the amplifier and C/N is not deteriorated in the tuner 41a. Accordingly, reception error does not occur after the demodulation step.

Further, according to the second embodiment, it is possible to automatically switch between the amplifier 22a and the bypass circuit 25 in the antenna block 20a using the level of the received signal detected by the tuner module 40a.

According to the first aspect of the invention, there is provided a diversity receiver which includes: a plurality of antenna blocks each having an antenna and an amplifier coupled to the antenna; a plurality of tuner modules each having a tuner and an OFDM demodulator connected to the tuner, and each connected to an output terminal of each of the antenna blocks; and a synthesizer that synthesizes demodulated signals output from the tuner modules. In the diversity receiver, when the level of a received signal is greater than a predetermined value, the level of the received signal input to the amplifier of at least one of the antenna blocks is lowered or becomes zero, and the level of the received signal is input to the amplifier of at least another one of the antenna blocks regardless of change of the level of the received signal without changing the level of the received signal. Accordingly, in a weak electric field, the received signal is amplified by the amplifier and input to the tuner, thereby improving reception sensitivity. In addition, in a strong electric field, since deformation occurring in the amplifier of at least one of the antenna blocks is prevented, C/N is not deteriorated in the tuner, causing the reception error not to occur after a demodulation step. Further, since at least another antenna block receives signals regardless of the magnitude of the electric field intensity, synchronization does not fail in a synthesizing step after the OFDM demodulation even though the electric field intensity weakens.

According to the second aspect of the invention, the diversity receiver is configured such that the at least one of the antenna blocks includes a variable attenuator that is located at a front stage of the amplifier, the tuner module connected to the at least one of the antenna blocks includes an AGC generation circuit that generates an AGC voltage which changes when the level of the received signal is greater than the predetermined value, and the amount of attenuation of the variable attenuator is controlled by the AGC voltage. Accordingly, the level of the received signal that is input to the amplifier is lowered.

According to the third aspect of the invention, the diversity receiver is configured such that the received signal output from each antenna block is input to the tuner module through a first cable, the AGC voltage is input to the variable attenuator through a second cable, the tuner module includes a power supply unit that additionally supplies a power supply voltage to the first cable, and the power supply voltage is supplied from the first cable to the amplifier. Accordingly, even though the antenna block is mounted on a front glass of a vehicle separated from the tuner module, an extra power source does not need to be provided on the antenna block.

According to the fourth aspect of the invention, the diversity receiver is configured such that a bypass circuit is provided parallel to the amplifier of the at least one of the antenna blocks to bypass the amplifier, and the received signal is output through the bypass circuit, instead of being input to the amplifier of the at least one of the antenna blocks, only when the level of the received signal is greater than the predetermined value. Accordingly, the received signal is not input to the amplifier of the at least one of the antenna blocks.

According to the fifth aspect of the invention, the diversity receiver is configured such that the at least one of the antenna blocks includes a switch diode that is interposed between the antenna and the amplifier, the bypass circuit is formed of a switch that is connected between an input terminal of the switch diode and an output terminal of the amplifier, and, when the level of the received signal is greater than the predetermined value, the switch diode is turned off and, at the same time, the switch is turned on. Accordingly, the received signal can be output through the bypass circuit.

According to the sixth aspect of the invention, the diversity receiver is configured such that the received signal output from each of the antenna blocks is input to each of the tuner modules through a first cable, each of the tuner modules includes a power supply unit that supplies a power supply voltage to the first cable, the power supply voltage is supplied to each amplifier through each cable, and the tuner module connected to the at least one of the antenna blocks stops supplying the power supply voltage to the first cable by means of the power supply unit when the level of the received signal is greater than the predetermined value, such that the switch diode is turned off and, at the same time, the switch is turned on. Accordingly, even though the antenna block is mounted on a front glass of a vehicle separated from the tuner module, an extra power source does not need to be provided on the antenna block.

According to the seventh aspect of the invention, the diversity receiver is configured such that the switch is formed of an FET, an anode of the switch diode is coupled to an input terminal of the amplifier, a cathode of the switch diode is coupled to the antenna, a source of the FET is connected to the cathode of the switch diode and is put to earth through a bias resistor, a gate of the FET is put to earth, and a drain of the FET is coupled to an output terminal of the amplifier. Accordingly, it is possible to turn off the switch diode and to turn on the switch by stopping supplying the power.

According to the eighth aspect of the invention, the diversity receiver is configured such that the tuner module connected to the at least one of the antenna blocks includes: a detector that detects the level of the received signal, and a comparator in which a reference voltage indicating the predetermined value is input to an input terminal of the comparator and a detected voltage from the detector is input to another terminal of the comparator, in which the power supply unit is formed of a transistor whose collector is connected to a power supply, whose emitter is connected to the first cable, and whose base is connected to an output terminal of the comparator. Accordingly, it is possible to automatically stop supplying the power when the level of the received signal is greater than a predetermined value.

## Claims

1. A diversity receiver comprising:
a plurality of antenna blocks (20) each having an antenna (21) and an amplifier (22) coupled to the antenna (21);
a plurality of tuner modules (40) each having a tuner (41) and an OFDM demodulator (42) connected to the tuner (41), and each connected to an output terminal of each of the antenna blocks (20); and
a synthesizer (60) that synthesizes demodulated signals output from the tuner modules (40),
**characterized in that**, when the level of a received signal is greater than a predetermined value, the level of the received signal input to the amplifier (22a) of at least one (20a) of the antenna blocks (20) is lowered or becomes zero, and the level of the received signal is input to the amplifier (22b) of at least another one (20b) of the antenna blocks (20) regardless of change of the level of the received signal without changing the level of the received signal.

2. The diversity receiver according to claim 1,
**characterized in that** the at least one (20a) of the antenna blocks (20) includes a variable attenuator (23) that is located at a front stage of the amplifier (22a), the tuner module (40a) connected to the at least one of the antenna blocks (20) includes an AGC generation circuit (45) that generates an AGC voltage which changes when the level of the received signal is greater than the predetermined value, and the amount of attenuation of the variable attenuator (23) is controlled by the AGC voltage.

3. The diversity receiver according to claim 2,
**characterized in that** the received signal output from each antenna block (20) is input to the tuner module (40) through a first cable (30), the AGC voltage is input to the variable attenuator (23) through a second cable (31), the tuner module (40) includes a power supply unit (43) that additionally supplies a power supply voltage to the first cable (30), and the power supply voltage is supplied from the first cable (30) to the amplifier (22).

4. The diversity receiver according to any of claims 1-3,
**characterized in that** a bypass circuit (25) is provided parallel to the amplifier (23a) of the at least one (20a) of the antenna blocks (20) to bypass the amplifier (22a), and the received signal is output through the bypass circuit (25), instead of being input to the amplifier (22a) of the at least one (20a) of the antenna blocks, only when the level of the received signal is greater than the predetermined value.

5. The diversity receiver according to claim 4,
**characterized in that** the at least one (20a) of the antenna blocks (20) includes a switch diode (24) that is interposed between the antenna (21a) and the amplifier (22a), the bypass circuit (25) is formed of a switch (25a) that is connected between an input terminal of the switch diode (24) and an output terminal of the amplifier (22a), and, when the level of the received signal is greater than the predetermined value, the switch diode (24) is turned off and, at the same time, the switch (25a) is turned on.

6. The diversity receiver according to claim 5,
**characterized in that** the received signal output from each of the antenna blocks (20) is input to each of the tuner modules (40) through a first cable (30), each of the tuner modules (40) includes a power supply unit (50) that supplies a power supply voltage to the first cable (30), the power supply voltage is supplied to each amplifier (22) through each cable (30), and the tuner module (40a) connected to the at least one (20a) of the antenna blocks (20) stops supplying the power supply voltage to the first cable (30a) by means of the power supply unit (50) when the level of the received signal is greater than the predetermined value, such that the switch diode (24) is turned off and, at the same time, the switch (25a) is turned on.

7. The diversity receiver according to claim 5 or 6,
**characterized in that** the switch (25a) is formed of an FET, an anode of the switch diode (24) is coupled to an input terminal of the amplifier (22a), a cathode of the switch diode (24) is coupled to the antenna (21a), a source of the FET (25a) is connected to the cathode of the switch diode (24) and is put to earth through a bias resistor (26), a gate of the FET (25a) is put to earth, and a drain of the FET (25a) is coupled to an output terminal of the amplifier (22a).

8. The diversity receiver according to any of claims 3-7,
**characterized in that** the tuner module (40a) connected to the at least one (20a) of the antenna blocks (20) includes:
a detector (44) that detects the level of the received signal, and
a comparator (49) in which a reference voltage indicating the predetermined value is input to an input terminal of the comparator and a detected voltage from the detector (44) is input to another terminal of the comparator, and
**characterized in that** the power supply unit (50) is formed of a transistor whose collector is connected to a power supply, whose emitter is connected to the first cable (30), and whose base is connected to an output terminal of the comparator (49).
